(19) Europäisches Patentamt
European Patent Office
Office européen des brevets

(11) **EP 2 774 268 B1**

(12) **FASCICULE DE BREVET EUROPEEN**

(45) Date de publication et mention
de la délivrance du brevet:
**23.01.2019 Bulletin 2019/04**

(21) Numéro de dépôt: **12770138.1**

(22) Date de dépôt: **11.10.2012**

(51) Int Cl.:
*H03H 9/02* (2006.01)   *H03H 9/24* (2006.01)
*H03H 3/007* (2006.01)   *H03H 3/02* (2006.01)
*H03H 9/15* (2006.01)

(86) Numéro de dépôt international:
**PCT/EP2012/070129**

(87) Numéro de publication internationale:
**WO 2013/064351 (10.05.2013 Gazette 2013/19)**

(54) **RÉSONATEUR THERMOCOMPENSÉ EN CÉRAMIQUE**

THERMOKOMPENSIERTER RESONATOR AUS KERAMIK

THERMALLY COMPENSATED CERAMIC RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.11.2011 EP 11187854**

(43) Date de publication de la demande:
**10.09.2014 Bulletin 2014/37**

(73) Titulaire: **The Swatch Group Research and Development Ltd.**
**2074 Marin (CH)**

(72) Inventeurs:
• **HESSLER, Thierry**
**CH-2024 St-Aubin (CH)**
• **DUBOIS, Philippe**
**CH-2074 Marin (CH)**
• **CONUS, Thierry**
**CH-2543 Lengnau (CH)**

(74) Mandataire: **Goulette, Ludivine et al**
**ICB**
**Ingénieurs Conseils en Brevets SA**
**Faubourg de l'Hôpital 3**
**2001 Neuchâtel (CH)**

(56) Documents cités:
EP-A1- 1 422 436      WO-A1-2008/043727
WO-A1-2009/068091     WO-A1-2011/072960
WO-A2-2007/059876

• **FUJISHIMA S: "The history of ceramic filters", IEEE TRANSACTIONS ON ULTRASONICS, FERROELECTRICS AND FREQUENCY CONTROL, IEEE, US, vol. 47, no. 1, 1 January 2000 (2000-01-01), pages 1-7, XP011438033, ISSN: 0885-3010, DOI: 10.1109/58.818743**

**Description**

Domaine de l'invention

L'invention se rapporte à un résonateur thermocompensé du type balancier-spiral, diapason ou plus généralement MEMS permettant de fabriquer une base de temps ou de fréquence dont les coefficients thermiques sont sensiblement nuls au premier ordre voire au deuxième ordre.

Arrière plan de l'invention

Les documents EP 1 422 436 et WO 2009/068091 divulguent un spiral formé en silicium et recouvert de dioxyde de silicium afin de rendre le coefficient thermique sensiblement nul autour des températures de procédure COSC, c'est-à-dire entre +8 et +38 °C. De même, le document WO 2008-043727 divulgue un résonateur MEMS qui possède des qualités similaires de faible dérive de son module d'Young dans la même plage de température.

Cependant la dérive de la fréquence des divulgations ci-dessus peut nécessiter des corrections complexes selon les applications. Par exemple, pour que des montres électroniques à quartz puissent être certifiées COSC, une correction électronique basée sur une mesure de la température doit être effectuée.

Le document WO 2011/072960 divulgue un spiral en silicium revêtu de dioxyde de silicium et de dioxyde de germanium afin de compenser deux ordres du coefficient thermique du module d'Young du silicium.

L'article de M. Saturo Fujushima intitulé « The history of ceramic filters » est issu de la publication « IEEE Transactions on ultrasonics, Ferroelectrics, and Frequency control », vol. 47, N°1, janvier 2000, IEEE. L'article divulgue l'histoire des filtres céramiques pour la démodulation des ondes radio et particulièrement celle des céramiques piézoélectriques PZT.

Le document WO 2007/059876 propose de fabriquer un spiral en modifiant des zones d'une plaquette de verre photostructurable afin de remplacer le coefficient thermique du module d'Young du verre photostructurable par un ou plusieurs autres afin d'obtenir des coefficients thermiques du module d'Young différents le long du spiral.

Résumé de l'invention

Le but de la présente invention est de pallier tout ou partie les inconvénients cités précédemment en proposant un résonateur en céramique compensé thermiquement au moins au premier ordre.

A cet effet, l'invention se rapporte à un résonateur thermocompensé comportant un corps utilisé en déformation, l'âme du corps étant formée par du verre de quartz, du verre borosilicate ou du verre aluminosilicate, du zerodur du carbure de silicium sous forme cristalline ou du verre métallique caractérisé en ce qu'au moins une partie du corps comporte un revêtement dont les variations du module d'Young en fonction de la température sont de signe opposé à celles du matériau utilisé pour l'âme afin de permettre audit résonateur d'avoir une variation de fréquence en fonction de la température au moins au premier ordre sensiblement nulle.

Selon l'invention, le corps du résonateur utilisé en déformation comporte un seul revêtement pour compenser un ou deux ordres. Ainsi, suivant les grandeurs et les signes de chaque ordre du matériau de revêtement, le calcul de l'épaisseur du revêtement est effectué afin de compenser au moins le premier ordre.

Conformément à d'autres caractéristiques avantageuses de l'invention :

- le corps comporte une section sensiblement en forme d'un quadrilatère dont les faces sont identiques deux à deux ;
- le corps comporte une section sensiblement en forme d'un quadrilatère dont les faces sont entièrement revêtues ;
- ledit au moins un revêtement forme une barrière contre l'humidité ;
- ledit au moins un revêtement est électriquement conducteur ;
- le corps comporte une couche d'accrochage entre l'âme et ledit au moins un revêtement ;
- le corps est un barreau enroulé sur lui-même en formant un spiral et est couplé avec un volant d'inertie ;
- le corps comporte au moins deux barreaux montés symétriquement afin de former un diapason ;
- le corps est un résonateur MEMS.

Enfin, l'invention se rapporte également à une base de temps ou de fréquence, comme par exemple une pièce d'horlogerie, caractérisée en ce qu'elle comporte au moins un résonateur conforme à l'une des variantes précédentes.

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation en perspective d'une partie d'un résonateur balancier - spiral ;
- la figure 2 est une section représentative du ressort-spiral de la figure 1 ;
- les figures 3 et 4 sont des alternatives de sections d'un résonateur selon l'invention ;
- la figure 5 est une représentation générale en perspective d'un résonateur du type diapason ;
- les figures 6 et 7 sont des alternatives de sections d'un résonateur selon l'invention.

Description détaillée des modes de réalisation préférés

Comme expliqué ci-dessus, l'invention se rapporte à une pièce d'horlogerie comportant un résonateur qui peut être du type balancier-spiral, diapason ou plus généralement un résonateur du type MEMS (abréviation provenant des termes anglais « Micro Electro-Mechanical System »). Afin d'apporter une explication plus simple de l'invention, seules les applications à un balancier-spiral et à un diapason sont présentées ci-dessous. Cependant, d'autres applications pour le résonateur seront réalisables pour un homme du métier sans difficultés excessives à partir de l'enseignement ci-dessous.

A titre de définition, la variation relative de la fréquence d'un résonateur suit la relation suivante :

$$\frac{\Delta f}{f_0} = A + \alpha \cdot (T - T_0) + \beta \cdot (T - T_0)^2 + \gamma \cdot (T - T_0)^3$$

où :

- $\dfrac{\Delta f}{f_0}$ est la variation relative de fréquence (ppm ou $10^{-6}$) ;
- $A$ une constante qui dépend du point de référence (ppm) ;
- $T_0$ la température de référence (°C) ;
- $\alpha$ le coefficient thermique du premier ordre (ppm. °C$^{-1}$) ;
- $\beta$ le coefficient thermique du deuxième ordre (ppm. °C$^{-2}$) ;
- $\gamma$ le coefficient thermique du troisième ordre (ppm. °C$^{-3}$).

De plus, le coefficient thermoélastique (*CTE*) représente la variation relative du module d'Young en fonction de la température. Les termes « $\alpha$ » et « $\beta$ » qui sont utilisés ci-dessous représentent ainsi respectivement les coefficients thermiques des premier et deuxième ordres, c'est-à-dire la variation relative de la fréquence du résonateur en fonction de la température. Les termes « $\alpha$ » et « $\beta$ » dépendent du coefficient thermoélastique du corps du résonateur et des coefficients de dilatation du corps. De plus, les termes « $\alpha$ » et « $\beta$ » prennent également en compte les coefficients propres à une éventuelle inertie séparée, telle que, par exemple, le balancier (formant un volant d'inertie) pour un résonateur balancier - spiral.

Les oscillations de tout résonateur destiné à une base de temps ou de fréquence devant être entretenues, la dépendance thermique comprend également une contribution éventuelle du système d'entretien.

Le paramètre le plus important est donc le coefficient thermoélastique (*CTE*) qu'il ne faut pas confondre avec l'abréviation anglaise CTE pour « Constant of Thermal Expansion » qui concerne le coefficient de dilatation.

Le coefficient thermoélastique (*CTE*) de la plupart des métaux est très négatif, de l'ordre de -1000 ppm. °C$^{-1}$. Il est par conséquent inimaginable de les utiliser pour réaliser un spiral. Des alliages complexes ont donc été développés, comme le Nivarox CT, afin de répondre à cette problématique. Ils restent toutefois difficiles à maîtriser notamment quant à leur fabrication.

L'invention se rapporte à des matériaux alternatifs en céramique, comme définis dans les revendications, pour former lesdits résonateurs. Une céramique peut être considérée comme un article ayant un corps vitrifié ou non, de structure cristalline ou partiellement cristalline, ou de verre, dont le corps est formé de substances essentiellement inorganiques et métalliques ou non, et qui est formé par une masse en fusion qui se solidifie en se refroidissant, ou qui est formé et porté à maturité, en même temps ou ultérieurement, par l'action de la chaleur.

Une céramique selon l'invention englobe donc des verres de quartz, des verres borosilicates, des verres aluminosilicates des verres métalliques, du carbure de silicium ou du zérodur. Ainsi, selon l'invention, le résonateur comporte un revêtement dont les variations du module d'Young en fonction de la température sont de signe opposé à celles de la céramique utilisée pour l'âme afin de permettre audit résonateur d'avoir une variation de fréquence en fonction de la température au moins au premier ordre sensiblement nulle.

Il est également intéressant que le revêtement puisse être électriquement conducteur afin d'éviter que le déplacement du corps puisse générer des forces électrostatiques propres à influencer la trajectoire du corps. Enfin, il est également préférable que le revêtement offre une perméabilité propre à former une barrière contre l'humidité comme par exemple du nitrure de silicium.

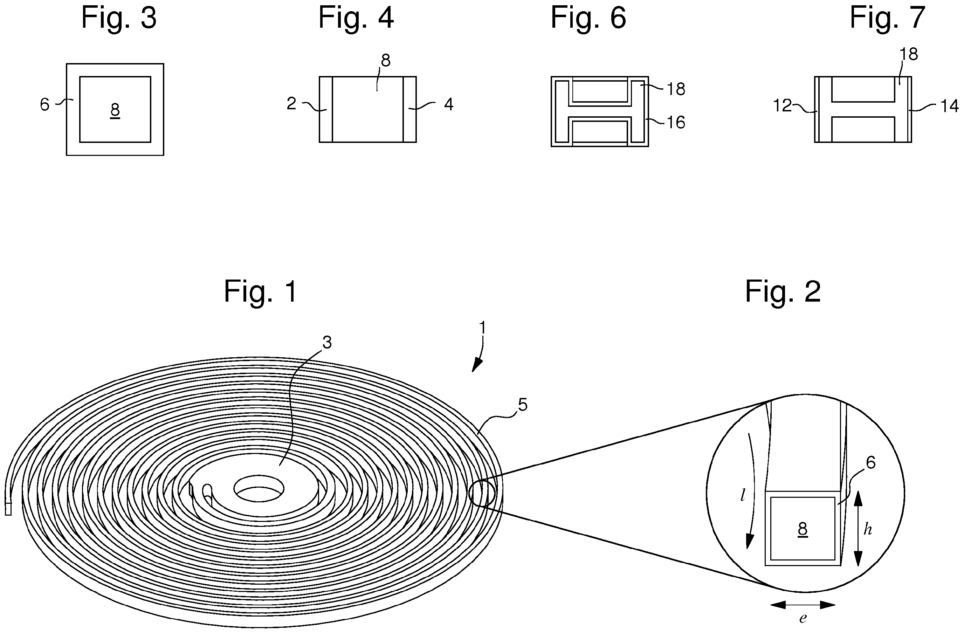

Dans un exemple illustré aux figures 1 et 2, on peut voir un spiral 1 dont le corps 5 est venu de forme avec sa virole 3 et dont les coefficients thermiques au premier ordre $\alpha$ voire au deuxième ordre $\beta$ sont compensés par l'utilisation de deux matériaux pour respectivement l'âme 8 et le revêtement 6. La figure 2 propose une coupe du corps 5 du spiral 1 permettant de mieux voir sa section en forme de quadrilatère. Le corps 5 peut ainsi être défini par sa longueur $l$, sa hauteur $h$ et son épaisseur e.

La figure 2 montre un exemple où l'âme 8 est entièrement revêtue. Bien évidemment, la figure 2 présente uniquement un exemple non limitatif. Ainsi, le spiral 1 peut comporter un revêtement 2, 4, 6 sur au moins une partie comme une ou plusieurs faces ou même la totalité de la surface extérieure du corps 5 comme les exemples illustrés aux figures 3 et 4. A titre informatif, les revêtements 2, 4, 6 ne sont pas à l'échelle par rapport aux dimensions de l'âme 8, ceci afin de mieux montrer les localisations de chaque partie.

On comprend donc que le corps selon l'invention peut comporter de manière non limitative une section sensiblement en forme d'un quadrilatère dont une seule face est revêtue ou dont les faces sont identiques deux à deux ou encore dont les faces sont entièrement revêtues de manière identique ou pas.

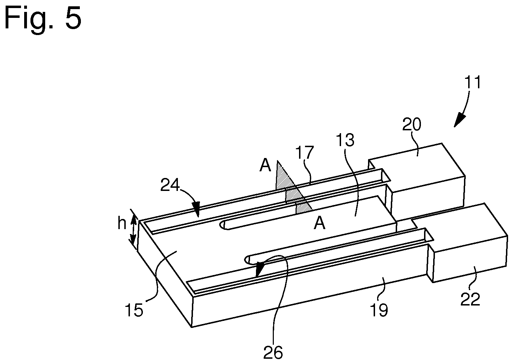

De manière similaire, avantageusement selon l'invention, on peut voir un résonateur 11 du type diapason à la figure 5. Le corps 15 du résonateur est formé d'une base 13 raccordée à deux bras 17, 19 destinés à osciller. A titre d'exemple, le diapason 11 utilisé est du type inversé, c'est-à-dire que la base 13 se prolonge entre les deux bras 17, 19, du type palmé, c'est-à-dire que les deux bras 17, 19 comportent à leur extrémité des palmes 20, 22 et du type rainuré (également connu sous le nom anglais « groove »), c'est-à-dire que les deux bras 17, 19 comportent des rainures 24, 26. On comprend toutefois qu'il existe une multitude de variantes possibles de diapasons qui peuvent, de manière non exhaustive, être du type inversé et/ou du type rainuré et/ou du type conique et/ou du type palmé.

Le diapason 11, selon l'invention, comporte des coefficients thermiques au premier ordre $\alpha$ voire au deuxième ordre $\beta$ qui sont compensés par le dépôt d'une couche 12, 14, 16 contre l'âme 18 du corps 15. Les figures 6 et 7 proposent deux exemples non exhaustifs de coupe du corps 15 du diapason 11 selon le plan A-A. Les sections en forme de quadrilatère rainuré montrent l'âme 18 du corps 15 recouvert d'au moins un revêtement 12, 14, 16 sur au moins une partie comme une ou plusieurs faces ou même la totalité de la surface extérieure du corps 15. Comme pour le premier exemple, les revêtements 12, 14, 16 ne sont pas à l'échelle par rapport aux dimensions de l'âme 18, ceci afin de mieux montrer les localisations de chaque partie.

L'âme 8, 18 du résonateur 1, 11 est formé par de la céramique. Toutefois, il existe une grande variété de céramiques. C'est pourquoi, des céramiques qui possèdent de faibles coefficients thermoélastiques (*CTE*) et de dilatation ($\alpha_{\text{spi}}$) sont préférés.

Il est ainsi possible d'utiliser du verre de quartz également appelé quartz fondu (en anglais « fused quartz »). Contrairement à ce que laisse penser l'utilisation du mot quartz, il ne s'agit pas d'un matériau cristallin mais d'une silice amorphe.

Suivant la méthode de fabrication du verre de quartz, la valeur du coefficient thermoélastique (*CTE*) obtenue est généralement faible et positive, c'est-à-dire comprise entre 50 et 250 ppm. $^{\circ}\text{C}^{-1}$. De plus, le coefficient de dilatation $\alpha_{\text{spi}}$ du verre de quartz est d'environ 0,5·ppm. $^{\circ}\text{C}^{-1}$, ce qui est très faible. Cela signifie pour l'exemple du verre de quartz que le revêtement 2, 4, 6, 12, 14, 16 comporte préférentiellement un coefficient thermoélastique (*CTE*) qui est négatif. Comme expliqué ci-dessus, le tel revêtement peut donc comporter un métal ou un alliage métallique ou une autre céramique comme du carbure de silicium.

Bien entendu, d'autres verres de la famille des silicates alcalins, des borosilicates ou des aluminosilicates sont parfaitement envisageables :

| *CTE* (ppm. $^{\circ}\text{C}^{-1}$) | Matériau |
|---|---|
| - 209 | Verre à la soude |
| - 35 | Verre Sibor |
| - 48 | Borosilicate (a) |
| + 117 | Borosilicate (b) |
| - 18 | Aluminosilicate (a) |
| - 70 | Aluminosilicate (b) |

A titre d'exemple, le pyrex® ou les verres BF33, AF45 de la société Schott® peuvent être utilisés :

|  | BF33 | AF45 |
|---|---|---|
| $SiO_2$ | 81 | 50 |
| $B_2O_3$ | 13 | 14 |
| $Al_2O_3$ | 2 | 11 |
| BaO |  | 24 |
| $Na_2O - K_2O$ | 4 |  |
| $\alpha_{spi}$ (ppm. $°C^{-1}$) | 3.25 | 4.5 |
| $CTE$ (ppm. $°C^{-1}$) | >0 | >0 |

où :

- $\alpha_{spi}$ est le coefficient de dilatation du matériau (ppm. $°C^{-1}$) ;
- $CTE$ est le coefficient thermoélastique du matériau (ppm. $°C^{-1}$).

Des verres photostructurables tels que divulgués dans le document WO 2007/059876 sont également envisageables. En effet, le procédé de fabrication du type photolithographie est très précis pour l'ajustement du coefficient thermoélastique ($CTE$). Enfin, des verres céramiques, comme par exemple du zérodur, sont également envisageables.

Comme expliqué ci-dessus, on comprend que les céramiques peuvent comporter aussi bien des coefficients thermoélastiques ($CTE$) positifs que négatifs au premier ordre et au deuxième ordre. C'est pourquoi le ou les revêtements 2, 4, 6, 12, 14, 16, utilisés pour l'âme 8, 18 peuvent incidemment comporter aussi bien des coefficients thermoélastiques ($CTE$) négatifs que positifs au premier ordre et au deuxième ordre. On comprend donc que le résonateur 1, 11 peut être formé par exemple par une âme en céramique totalement ou partiellement recouvert d'un revêtement également en céramique.

Ainsi, suivant la méthode de dépôt du revêtement 2, 4, 6, 12, 14, 16, il peut être préférable de choisir un matériau comportant une bonne adhérence par rapport à la céramique comme du chrome ou du titane. Toutefois, en alternative, une couche d'accrochage comme du chrome ou du titane peut également être déposée préalablement au revêtement principal 2, 4, 6, 12, 14, 16 pour améliorer l'adhérence et/ou la perméabilité dudit revêtement.

Enfin, dans le cas où l'âme 8, 18 comporterait un coefficient thermoélastiques ($CTE$) négatif au premier ordre voire au deuxième ordre, préférentiellement, de l'oxyde de germanium ($GeO_2$), de l'oxyde de tantale ($Ta_2O_5$) et/ou des oxydes de zirconium ou d'hafnium sont utilisables comme revêtements.

Des exemples ont été recherchés en considérant un résonateur à 4 Hz avec un balancier d'une inertie de 16 mg·$cm^2$. Le coefficient de dilatation du balancier $\alpha_{bal}$ influence la dépendance thermique de la fréquence du résonateur.

Pour le spiral, hauteur $h$ et longueur $l$ des spires sont fixes, seule leur épaisseur $e$ est ajustée afin d'obtenir le bon couple. L'épaisseur $d$ du revêtement, supposé recouvrir toutes les faces des spires, est ajustée pour qu'il y ait compensation thermique au moins au premier ordre $\alpha$ de la fréquence du résonateur.

Les propriétés des matériaux utilisés pour l'âme ou le revêtement du spiral sont résumées dans le tableau suivant :

|  | $E$ (Gpa) | $CTE$ (ppm. $°C^{-1}$) | $\alpha_{spi}$ (ppm. $°C^{-1}$) |
|---|---|---|---|
| Zerodur | 90 | 76 | 0,0 |
| Al | 68 | -430 | 24,0 |
| CVD-SiC | 466 | -50 | 2,2 |
| 6H-SiC | 220 | -12 | 2,8 |
| $SiO_2$ | 72 | 215 | 0,4 |
| Verre Métallique | 117 | -160 | 12,0 |
| $TeO_2$ | 51 | 40'000 | 15,5 |

Un premier exemple consiste à enrober par un métal (ici une couche d'Al) un spiral en zerodur vendu par la société Schott® avec un coefficient de dilatation sensiblement nul.

Ce verre pourrait également être enrobé par une couche de SiC déposée par dépôt chimique en phase vapeur (également connu sous l'abréviation anglaise « CVD »). Le CVD-SiC est un matériau polycristallin réputé résistant mécaniquement et chimiquement. Le SiC existe aussi sous forme cristalline par exemple hexagonale sous le nom de 6H-SiC. Les propriétés de ce dernier diffèrent de celles de forme polycristalline. Dans l'exemple ci-dessous, il est compensé par du $SiO_2$.

Finalement, un dernier exemple est pris à partir d'un verre métallique compensé par une couche de $TeO_2$.

Un tableau récapitule les différents exemples :

| Ame | Revêtement | $\alpha_{bal}$ (ppm. °C$^{-1}$) | e ($\mu$m) |
|---|---|---|---|
| Zerodur | Al | 10 | 1.15 |
| Zerodur | CVD-SiC | 15 | 0.79 |
| 6H-SiC | $SiO_2$ | 10 | 1.77 |
| Verre Métallique | $TeO_2$ | 15 | 0.06 |

**Revendications**

1. Résonateur (1, 11) thermocompensé comportant un corps (5, 15) utilisé en déformation, l'âme (8, 18) du corps (5, 15) étant formée par du verre de quartz, du verre borosilicate ou du verre aluminosilicate, au moins une partie du corps (5, 15) comportant un revêtement (2, 4, 6, 12, 14, 16) dont les variations du module d'Young en fonction de la température (*CTE*) sont de signe opposé à celles (*CTE*) du matériau utilisé pour l'âme (8, 18) afin de permettre audit résonateur d'avoir une variation de fréquence en fonction de la température au moins au premier ordre ($\alpha$, $\beta$) sensiblement nulle.

2. Résonateur (1, 11) selon la revendication précédente, **caractérisé en ce que** ledit revêtement (2, 4, 6, 12, 14, 16) comporte un métal ou un alliage métallique.

3. Résonateur (1, 11) selon la revendication précédente, **caractérisé en ce que** ledit revêtement (2, 4, 6, 12, 14, 16) comporte du chrome ou du titane.

4. Résonateur (1, 11) selon la revendication 1, **caractérisé en ce que** ledit revêtement (2, 4, 6, 12, 14, 16) comporte du carbure de silicium.

5. Résonateur (1, 11) thermocompensé comportant un corps (5, 15) utilisé en déformation, l'âme (8, 18) du corps (5, 15) étant formée par du zerodur, au moins une partie du corps (5, 15) comportant un revêtement (2, 4, 6, 12, 14, 16) dont les variations du module d'Young en fonction de la température (*CTE*) sont de signe opposé à celles (*CTE*) du matériau utilisé pour l'âme (8, 18) afin de permettre audit résonateur d'avoir une variation de fréquence en fonction de la température au moins au premier ordre ($\alpha$, $\beta$) sensiblement nulle.

6. Résonateur (1, 11) selon la revendication précédente, **caractérisé en ce que** ledit revêtement (2, 4, 6, 12, 14, 16) comporte un métal.

7. Résonateur (1, 11) selon la revendication 5, **caractérisé en ce que** ledit revêtement (2, 4, 6, 12, 14, 16) comporte du chrome, de l'aluminium ou du titane.

8. Résonateur (1, 11) selon la revendication 5, **caractérisé en ce que** ledit revêtement (2, 4, 6, 12, 14, 16) comporte du carbure de silicium.

9. Résonateur (1, 11) thermocompensé comportant un corps (5, 15) utilisé en déformation, l'âme (8, 18) du corps (5, 15) étant formée par du carbure de silicium sous forme cristalline, au moins une partie du corps (5, 15) comportant un revêtement (2, 4, 6, 12, 14, 16) dont les variations du module d'Young en fonction de la température (CTE) sont de signe opposé à celles (CTE) du matériau utilisée pour l'âme (8, 18) afin de permettre audit résonateur d'avoir une variation de fréquence en fonction de la température au moins au premier ordre ($\alpha$, $\beta$) sensiblement nulle.

10. Résonateur (1, 11) selon la revendication précédente, **caractérisé en ce que** ledit revêtement (2, 4, 6, 12, 14, 16) comporte du dioxyde de silicium.

**11.** Résonateur (1, 11) selon la revendication 9, **caractérisé en ce que** ledit revêtement (2, 4, 6, 12, 14, 16) comporte du chrome ou du titane.

**12.** Résonateur (1, 11) thermocompensé comportant un corps (5, 15) utilisé en déformation, l'âme (8, 18) du corps (5, 15) étant formée par du verre métallique, au moins une partie du corps (5, 15) comportant un revêtement (2, 4, 6, 12, 14, 16) dont les variations du module d'Young en fonction de la température (CTE) sont de signe opposé à celles (CTE) du verre métallique utilisé pour l'âme (8, 18) afin de permettre audit résonateur d'avoir une variation de fréquence en fonction de la température au moins au premier ordre ($\alpha$, $\beta$) sensiblement nulle.

**13.** Résonateur (1, 11) selon la revendication précédente, **caractérisé en ce que** ledit revêtement (2, 4, 6, 12, 14, 16) comporte du dioxyde de tellure.

**14.** Résonateur (1, 11) selon la revendication 12, **caractérisé en ce que** ledit revêtement (2, 4, 6, 12, 14, 16) comporte du chrome ou du titane.

**15.** Résonateur (1, 11) selon l'une des revendications précédentes, **caractérisé en ce que** le corps (5, 15) comporte une section sensiblement en forme d'un quadrilatère dont les faces sont identiques deux à deux.

**16.** Résonateur (1, 11) selon la revendication 1 à 14, **caractérisé en ce que** le corps (5, 15) comporte une section sensiblement en forme d'un quadrilatère dont les faces sont entièrement revêtues.

**17.** Résonateur (1, 11) selon l'une des revendications précédentes, **caractérisé en ce que** le corps (1, 11) comporte une couche d'accrochage entre l'âme (8, 18) et ledit revêtement (2, 4, 6, 12, 14, 16).

**18.** Résonateur (1) selon l'une des revendications précédentes, **caractérisé en ce que** le corps (5) est un barreau enroulé sur lui-même en formant un spiral et est couplé avec un volant d'inertie.

**19.** Résonateur (11) selon l'une des revendications 1 à 17, **caractérisé en ce que** le corps (15) comporte au moins deux barreaux (17, 19) montés symétriquement afin de former un diapason.

**20.** Résonateur (1, 11) selon l'une des revendications 1 à 17, **caractérisé en ce que** le corps est un résonateur MEMS.

**21.** Pièce d'horlogerie **caractérisée en ce qu'**elle comporte au moins un résonateur (1, 11) conforme à l'une des revendications précédentes.

**Patentansprüche**

**1.** Thermokompensierter Resonator (1, 11), umfassend einen Körper (5, 15), dessen Verformungsverhalten genutzt wird, wobei die Seele (8, 18) des Körpers (5, 15) aus Quarzglas, Borsilikatglas oder Aluminosilikatglas gebildet ist, wobei mindestens ein Teil des Körpers (5, 15) eine Beschichtung (2, 4, 6, 12, 14, 16) aufweist, deren Veränderungen des Elastizitätsmoduls als Funktion der Temperatur (CTE) ein entgegengesetztes Vorzeichen gegenüber jenen (CTE) des für die Seele (8, 18) verwendeten Materials aufweisen, um dem Resonator eine Frequenzveränderung als Funktion der Temperatur zu ermöglichen, die mindestens in der ersten Ordnung ($\alpha$, $\beta$) im Wesentlichen null ist.

**2.** Resonator (1, 11) nach dem vorhergehenden Anspruch, **dadurch gekennzeichnet, dass** die Beschichtung (2, 4, 6, 12, 14, 16) ein Metall oder eine Metalllegierung enthält.

**3.** Resonator (1, 11) nach dem vorhergehenden Anspruch, **dadurch gekennzeichnet, dass** die Beschichtung (2, 4, 6, 12, 14, 16) Chrom oder Titan enthält.

**4.** Resonator (1, 11) nach Anspruch 1, **dadurch gekennzeichnet, dass** die Beschichtung (2, 4, 6, 12, 14, 16) Siliciumcarbid enthält.

**5.** Thermokompensierter Resonator (1, 11), umfassend einen Körper (5, 15), dessen Verformungsverhalten genutzt wird, wobei die Seele (8, 18) des Körpers (5, 15) aus Zerodur gebildet ist, wobei mindestens ein Teil des Körpers (5, 15) eine Beschichtung (2, 4, 6, 12, 14, 16) aufweist, deren Veränderungen des Elastizitätsmoduls als Funktion der Temperatur (CTE) ein entgegengesetztes Vorzeichen gegenüber jenen (CTE) des für die Seele (8, 18) verwendeten Materials aufweisen, um dem Resonator eine Frequenzveränderung als Funktion der Temperatur zu ermöglichen, die mindestens in der ersten Ordnung ($\alpha$, $\beta$) im Wesentlichen null ist.

6.  Resonator (1, 11) nach dem vorhergehenden Anspruch, **dadurch gekennzeichnet, dass** die Beschichtung (2, 4, 6, 12, 14, 16) ein Metall enthält.

7.  Resonator (1, 11) nach Anspruch 5, **dadurch gekennzeichnet, dass** die Beschichtung (2, 4, 6, 12, 14, 16) Chrom, Aluminium oder Titan enthält.

8.  Resonator (1, 11) nach Anspruch 5, **dadurch gekennzeichnet, dass** die Beschichtung (2, 4, 6, 12, 14, 16) Siliciumcarbid enthält.

9.  Thermokompensierter Resonator (1, 11), umfassend einen Körper (5, 15), dessen Verformungsverhalten genutzt wird, wobei die Seele (8, 18) des Körpers (5, 15) aus Siliciumcarbid in kristalliner Form gebildet ist, wobei mindestens ein Teil des Körpers (5, 15) eine Beschichtung (2, 4, 6, 12, 14, 16) aufweist, deren Veränderungen des Elastizitätsmoduls als Funktion der Temperatur (*CTE*) ein entgegengesetztes Vorzeichen gegenüber jenen (*CTE*) des für die Seele (8, 18) verwendeten Materials aufweisen, um dem Resonator eine Frequenzveränderung als Funktion der Temperatur zu ermöglichen, die mindestens in der ersten Ordnung ($\alpha$, $\beta$) im Wesentlichen null ist.

10. Resonator (1, 11) nach dem vorhergehenden Anspruch, **dadurch gekennzeichnet, dass** die Beschichtung (2, 4, 6, 12, 14, 16) Siliciumdioxid enthält.

11. Resonator (1, 11) nach Anspruch 9, **dadurch gekennzeichnet, dass** die Beschichtung (2, 4, 6, 12, 14, 16) Chrom oder Titan enthält.

12. Thermokompensierter Resonator (1, 11), umfassend einen Körper (5, 15), dessen Verformungsverhalten genutzt wird, wobei die Seele (8, 18) des Körpers (5, 15) aus amorphem Metall gebildet ist, wobei mindestens ein Teil des Körpers (5, 15) eine Beschichtung (2, 4, 6, 12, 14, 16) aufweist, deren Veränderungen des Elastizitätsmoduls als Funktion der Temperatur (*CTE*) ein entgegengesetztes Vorzeichen gegenüber jenen (*CTE*) des für die Seele (8, 18) verwendeten amorphen Metalls aufweisen, um dem Resonator eine Frequenzveränderung als Funktion der Temperatur zu ermöglichen, die mindestens in der ersten Ordnung ($\alpha$, $\beta$) im Wesentlichen null ist.

13. Resonator (1, 11) nach dem vorhergehenden Anspruch, **dadurch gekennzeichnet, dass** die Beschichtung (2, 4, 6, 12, 14, 16) Tellurdioxid enthält.

14. Resonator (1, 11) nach Anspruch 12, **dadurch gekennzeichnet, dass** die Beschichtung (2, 4, 6, 12, 14, 16) Chrom oder Titan enthält.

15. Resonator (1, 11) nach einem der vorhergehenden Ansprüche, **dadurch gekennzeichnet, dass** der Körper (5, 15) einen Abschnitt aufweist, der im Wesentlichen die Form eines Vierecks aufweist, dessen Flächen paarweise gleich sind.

16. Resonator (1, 11) nach Anspruch 1 bis 14, **dadurch gekennzeichnet, dass** der Körper (5, 15) einen Abschnitt aufweist, der im Wesentlichen die Form eines Vierecks aufweist, dessen Flächen vollständig beschichtet sind.

17. Resonator (1, 11) nach einem der vorhergehenden Ansprüche, **dadurch gekennzeichnet, dass** der Körper (1, 11) eine Haftschicht zwischen der Seele (8, 18) und der Beschichtung (2, 4, 6, 12, 14, 16) aufweist.

18. Resonator (1) nach einem der vorhergehenden Ansprüche, **dadurch gekennzeichnet, dass** der Körper (5) ein auf sich selbst gewickelter Stab ist, indem er eine Spirale bildet, und mit einem Schwungrad gekoppelt ist.

19. Resonator (11) nach einem der Ansprüche 1 ist 17, **dadurch gekennzeichnet, dass** der Körper (15) mindestens zwei Stäbe (17, 19) aufweist, die symmetrisch montiert sind, um eine Stimmgabel zu bilden.

20. Resonator (1, 11) nach einem der Ansprüche 1 bis 17, **dadurch gekennzeichnet, dass** der Körper ein MEMS-Resonator ist.

21. Zeitmessgerät, **dadurch gekennzeichnet, dass** es mindestens einen Resonator (1, 11) nach einem der vorhergehenden Ansprüche umfasst.

**Claims**

1. Temperature-compensated resonator (1, 11) comprising a body (5, 15) used in deformation, the core (8, 18) of the body (5, 15) being formed from quartz glass, borosilicate glass or aluminosilicate glass, at least part of the body (5, 15) comprising a coating (2, 4, 6, 12, 14, 16), whose Young's modulus variations with temperature (TEC) are of the opposite sign to those (TEC) of the material used for the core (8, 18), so as to enable said resonator to have a first-order ($\alpha$, $\beta$) frequency variation as a function of temperature that is substantially zero.

2. Resonator (1, 11) according to the preceding claim, **characterised in that** said coating (2, 4, 6, 12, 14, 16) comprises a metal or a metallic alloy.

3. Resonator (1, 11) according to the preceding claim, **characterised in that** said coating (2, 4, 6, 12, 14, 16) comprises chromium or titanium.

4. Resonator (1, 11) according to claim 1, **characterised in that** said coating (2, 4, 6, 12, 14, 16) comprises silicon carbide.

5. Temperature-compensated resonator (1, 11) comprising a body (5, 15) used in deformation, the core (8, 18) of the body (5, 15) being formed of Zerodur, at least part of the body (5, 15) comprising a coating (2, 4, 6, 12, 14, 16) whose Young's modulus variations with temperature (TEC) are of the opposite sign to those (TEC) of the material used for the core (8, 18), so as to enable said resonator to have a first-order ($\alpha$, $\beta$) frequency variation as a function of temperature that is substantially zero.

6. Resonator (1, 11) according to the preceding claim, **characterised in that** said coating (2, 4, 6, 12, 14, 16) comprises a metal.

7. Resonator (1, 11) according to claim 5, **characterised in that** said coating (2, 4, 6, 12, 14, 16) comprises chromium, aluminium or titanium.

8. Resonator (1, 11) according to claim 5, **characterised in that** said coating (2, 4, 6, 12, 14, 16) comprises silicon carbide.

9. Temperature-compensated resonator (1, 11) comprising a body (5, 15) used in deformation, the core (8, 18) of the body (5, 15) being formed of silicon carbide in crystalline form, at least part of the body (5, 15) comprising a coating (2, 4, 6, 12, 14, 16) whose Young's modulus variations with temperature (TEC) are of the opposite sign to those (TEC) of the material used for the core (8, 18), so as to enable said resonator to have a first-order ($\alpha$, $\beta$) frequency variation as a function of temperature that is substantially zero.

10. Resonator (1, 11) according to the preceding claim, **characterised in that** said coating (2, 4, 6, 12, 14, 16) comprises silicon dioxide.

11. Resonator (1, 11) according to claim 9, **characterised in that** said coating (2, 4, 6, 12, 14, 16) comprises chromium or titanium.

12. Temperature-compensated resonator (1, 11) comprising a body (5, 15) used in deformation, the core (8, 18) of the body (5, 15) being formed of metallic glass, at least part of the body (5, 15) comprising a coating (2, 4, 6, 12, 14, 16) whose Young's modulus variations with temperature (TEC) are of the opposite sign to those (TEC) of the metallic glass used for the core (8, 18), so as to enable said resonator to have a first-order ($\alpha$, $\beta$) frequency variation as a function of temperature that is substantially zero.

13. Resonator (1, 11) according to the preceding claim, **characterised in that** said coating (2, 4, 6, 12, 14, 16) comprises tellurium dioxide.

14. Resonator (1, 11) according to claim 12, **characterised in that** said coating (2, 4, 6, 12, 14, 16) comprises chromium or titanium.

**15.** Resonator (1, 11) according to any of the preceding claims, **characterised in that** the body (5, 15) comprises a cross section substantially in the form of a quadrilateral, the faces of which are identical in pairs.

**16.** Resonator (1, 11) according to claims 1 to 14, **characterised in that** the body (5, 15) comprises a cross section substantially in the form of a quadrilateral, the faces of which are fully coated.

**17.** Resonator (1, 11) according to any of the preceding claims, **characterised in that** the body (1, 11) comprises a primer layer between the core (8, 18) and said coating (2, 4, 6, 12, 14, 16).

**18.** Resonator (1) according to any of the preceding claims, **characterised in that** the body (5) is a bar wound around itself forming a balance spring and is coupled with an inertia flywheel.

**19.** Resonator (11) according to any of claims 1 to 17, **characterised in that** the body (15) comprises at least two bars (17, 19) mounted symmetrically in order to form a tuning fork.

**20.** Resonator (1, 11) according to any of claims 1 to 17, **characterised in that** the body is an MEMS resonator.

**21.** Timepiece **characterised in that** it comprises at least one resonator (1, 11) according to any of the preceding claims.

Fig. 7

Fig. 6

Fig. 4

Fig. 3

Fig. 2

Fig. 1

# Fig. 5

## RÉFÉRENCES CITÉES DANS LA DESCRIPTION

**Documents brevets cités dans la description**

- EP 1422436 A
- WO 2009068091 A
- WO 2008043727 A
- WO 2011072960 A
- WO 2007059876 A

**Littérature non-brevet citée dans la description**

- The history of ceramic filters. **M. SATURO.** IEEE Transactions on ultrasonics, Ferroelectrics, and Frequency control. IEEE, Janvier 2000, vol. 47